(19) **Europäisches Patentamt / European Patent Office / Office européen des brevets**

(11) **EP 4 123 907 B1**

(12) **EUROPEAN PATENT SPECIFICATION**

(45) Date of publication and mention
of the grant of the patent:
**03.07.2024 Bulletin 2024/27**

(21) Application number: **22176263.6**

(22) Date of filing: **31.05.2022**

(51) International Patent Classification (IPC):
*H03K 17/968* (2006.01) *H03K 17/945* (2006.01)
*G01S 17/08* (2006.01) *G01D 5/26* (2006.01)
*G01B 11/02* (2006.01) *G01D 5/30* (2006.01)
*G01S 7/481* (2006.01) *G01S 7/499* (2006.01)

(52) Cooperative Patent Classification (CPC):
**H03K 17/968; G01B 11/026; G01D 5/30;**
**G01S 7/4814; G01S 7/4816; G01S 7/499;**
**G01S 17/08; H03K 17/945**

(54) **OPTICAL PROXIMITY SYSTEM**

OPTISCHES NÄHERUNGSSYSTEM

SYSTÈME DE PROXIMITÉ OPTIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **19.07.2021 US 202117379492**

(43) Date of publication of application:
**25.01.2023 Bulletin 2023/04**

(73) Proprietor: **Northrop Grumman Systems
Corporation
Falls Church, VA 22042-4511 (US)**

(72) Inventors:
• **Meyer, A. Douglas
Woodland Hills, CA 91367 (US)**
• **Bolton, Thomas Alan
Lincoln, CA 95648 (US)**

(74) Representative: **Schmidt, Steffen J.
Wuesthoff & Wuesthoff
Patentanwälte und Rechtsanwalt PartG mbB
Schweigerstrasse 2
81541 München (DE)**

(56) References cited:
**EP-A1- 3 223 540**

• **SEIICHI KAKUMA ET AL: "Practical Accurate
Optical Ranging Based on Polarization Self
Modulation of a Vertical-Cavity Surface-Emitting
Laser Diode", OPTICAL REVIEW, SPRINGER,
BERLIN, DE, vol. 10, no. 6, 1 November 2003
(2003-11-01), pages 511-513, XP019353153, ISSN:
1349-9432, DOI: 10.1007/S10043-003-0511-Z**

**Description**

TECHNICAL FIELD

This disclosure relates generally to sensor systems, and specifically to an optical proximity system.

BACKGROUND

Proximity sensors perform non-contact detection of a distant object. Proximity sensors convert information on the movement or the presence of an object into an electrical signal. One type includes an inductive proximity sensor that detects magnetic loss due to eddy currents that are generated on a conductive surface by an external magnetic field. An AC magnetic field is generated on the detection coil, and changes in the impedance due to eddy currents generated on a metallic object are detected. Thus, inductive proximity sensors are limited to metallic objects. Another type includes a capacitive proximity sensor that detects changes in a capacitance between the sensor and the target object. Capacitive proximity sensors require an insulator or dielectric between the senor and the target object. In terrestrial applications, the air in the gap between the sensor and target object serves as the insulator or dielectric. Capacitive proximity sensors however, are ineffective in a space environment. Still another type of proximity sensor includes a magnetic proximity sensor. Magnetic proximity sensors detect a magnetic field generated by the target object (i.e., a magnet). Thus, magnetic proximity sensors are limited to detecting magnetic objects.

Prior art can be found in Seiichi Kakuma et al, "Practical Accurate Optical Ranging Based on Polarization Self Modulation of a Vertical-Cavity Surface-Emitting Laser Diode", ISSN: 1349-9432 and in EP 3 223 540 A1 which generally relates to an optical microphone system.

SUMMARY

The following presents a simplified summary in order to provide a basic understanding of the subject disclosure. This summary is not an extensive overview of the subject disclosure. It is not intended to identify key/critical elements or to delineate the scope of the subject disclosure. Its sole purpose is to present some concepts of the subject disclosure in a simplified form as a prelude to the more detailed description that is presented later.

An apparatus and a method according to the invention are defined in the appended independent claims. Preferred embodiments are defined in the dependent claims.

BRIEF DESCRIPTION OF THE DRAWINGS

The accompanying drawings, which are incorporated in and constitute a part of the specification, illustrate various systems, methods, and other examples of the disclosure. Illustrated element boundaries (e.g., boxes, groups of boxes, or other shapes) in the figures represent one example of the boundaries. In some examples one element may be designed as multiple elements or multiple elements may be designed as one element. In some examples, an element shown as an internal component of another element may be implemented as an external component and vice versa.

FIG. 1 illustrates an example optical proximity detection system with a fixed optical cavity length.
FIG. 2 is a graph illustrating a change in the optical cavity polarization switching frequency with respect to a change in length of the optical cavity.
FIG. 3 illustrates an example optical proximity sensor system.
FIG. 4 illustrates an example optical proximity detection system with a changing optical cavity length.
FIGS. 5A and 5B are intensity output plots from photodetectors in the example optical proximity detection system.
FIG. 6 is a plot of the optical cavity polarization switching frequency as a function of the optical cavity length.
FIG. 7 illustrates another example optical proximity detection system with a changing optical cavity length.
FIG. 8 illustrates still another example optical proximity detection system with a changing optical cavity length.
FIG. 9 illustrates an example of a method for measuring a distance to a target object.

DETAILED DESCRIPTION

The disclosure is now described with reference to the drawings, wherein like reference numerals are used to refer to like elements throughout. In the following description, for purposes of explanation, numerous specific details are set forth in order to provide a thorough understanding of the subject disclosure. It may be evident, however, that the subject disclosure can be practiced without these specific details. In other instances, well-known structures and devices are shown in block diagram form in order to facilitate describing the subject disclosure.

While specific characteristics are described herein (e.g., thickness, orientation, configuration, etc.), it is to be understood that the features, functions and benefits of the subject disclosure can employ characteristics that vary from those described herein.

Disclosed herein is an example optical proximity sensor system to determine a proximate location or distance to a target object for the purpose of positioning or coupling the two objects to one another. The optical proximity sensor system includes a laser, which could be configured as a vertical-cavity surface-emitting laser (VCSEL), that is configured to generate an optical beam at a first linear polarization (i.e., parallel or perpendicular). The optical proximity sensor system also includes an optical cavity that is formed by a target object and at least one photodetector. The target object can correspond to that to which proximity is being measured as a function of distance. Therefore, the target object can operate similar to a mirror in a traditional optical cavity, such that the light from the laser is reflected back from the target object toward the laser in the optical cavity.

The photodetector(s) can be arranged in a variety of ways to capture the light reflected back from the target object. For example, the photodetector(s) can substantially surround and can be arranged substantially planar with a gain region associated with the laser, and/or can be tapped-off from the optical cavity via polarizing beamsplitters. At least a portion of the reflected optical beam (i.e., from the target object) is received at the gain region of the laser. The reflected optical beam can be received at a second linear polarization opposite the first linear polarization (i.e., perpendicular or parallel, respectively). For example, the optical cavity system can include a quarter-wave plate arranged between the laser and the target object, such that the quarter-wave plate can convert the optical beam from the first linear polarization to a circular-polarization and convert the reflected optical beam from the circular-polarization to the second linear polarization, and vice-versa.

The reflected optical beam can thus stimulate the gain region of the laser to periodically oscillate between emitting the optical beam at the first linear polarization and the second linear polarization. Therefore, the photodetector(s) can be configured to detect the periodic oscillation based on transitions between the first and second linear polarizations of the optical beam. The photodetector(s) can be configured to generate a proximity signal that has a frequency associated with the periodic oscillation. The frequency of the periodic oscillation can vary based on a length of the optical cavity, and therefore the distance of the target object from the laser. The system can further include a proximity processor that is configured to calculate the distance of the target object based on the frequency of the distance signal, such as from a lookup table. Furthermore, to boost the signal-to-noise ratio (SNR) of the optical proximity sensor, and therefore to extend the range of the optical proximity sensor, the optical proximity sensor can also include a collimating lens to collimate the optical beam from the laser, thereby ensuring a greater amount of optical energy propagating within the optical cavity.

Thus, the optical proximity sensor system takes advantage of the polarization switching properties inherent in the VCSEL to determine a distance to a target object. Specifically, the formation of an external optical cavity and the feedback of an orthogonal polarization, with respect to the lasing polarization, into the VCSEL gain region causes the lasing polarization to switch, where a cavity polarization switching (PS) frequency (or optical cavity output frequency) Fc is dependent on the cavity length L. If the feedback can be injected in a periodic manner then the polarization can be made to switch with that period. If an external optical cavity is formed by placing the VCSEL on one end of an optical cavity having a fixed length and a mirror on an opposite end, the cavity PS-frequency Fc will be governed by Equation 1 below:

$$Fc = c/4*L \qquad\qquad (Eq.\ 1)$$

where c is the speed of light and L is the optical cavity length.

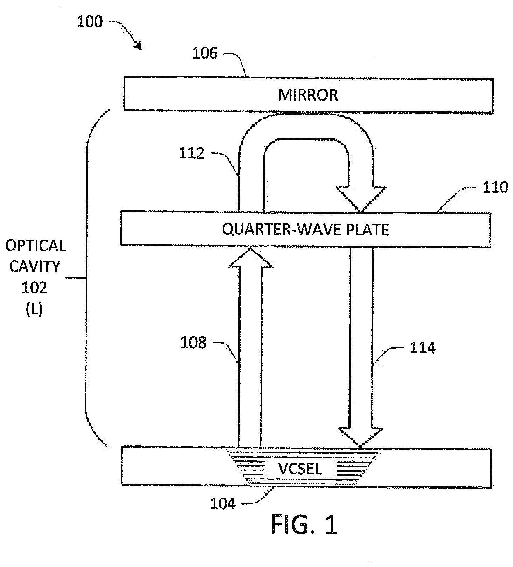

FIG. 1 is an illustration of a system 100 having an optical cavity 102 with a fixed length L. The system 100 includes a VCSEL 104 at one end of the optical cavity 102 and a fixed mirror 106 at an opposite end of the optical cavity 102. The VCSEL 104 is configured to generate an optical beam at a first linear polarization (i.e., parallel or perpendicular) 108. As evident by Equation 1, the cavity PS-frequency Fc is inversely proportional to the optical cavity length L for an optical cavity 102 having a fixed and stable cavity length. If a quarter-wave plate 110 is placed in the optical cavity 102 between the VCSEL 104 and the fixed mirror 106, the first linear polarization (i.e., parallel or perpendicular) 108 will change to a circular-polarization 112. Since the angle of incidence is perpendicular to the mirror 106 the reflected light will remain circularly polarized. When the reflected beam passes back through the quarter wave plate 110, the reflected beam is converted to a second linear polarization 114. The second state of linear polarization however, has rotated 90 degrees (i.e., perpendicular of parallel, respectively) from the first linear polarization 108. Thus as mentioned above, the quarter-wave plate 110 converts the optical beam from the first linear polarization 108 to the circular-polarization 112 and converts the reflected optical beam from the circular-polarization 112 to the second linear polarization 114.

Feeding the reflected beam back into a gain region of the VCSEL 104 will cause the polarization to flip to an orthogonal mode, which causes the optical signal to switch linear polarization state. Accordingly, the VCSEL 104 oscillates between the linear polarizations (i.e., perpendicular and parallel) in providing the optical beam. The optical cavity 102 formed by the VCSEL 104 and fixed mirror 106 is a resonant one. Thus, the polarization switching goes into a self-resonance causing the output polarization to change with every round trip of the optical cavity 102. Based on Equation 1, the cavity PS-frequency Fc for an optical cavity 102 one centimeter in length would be approximately 7.49 GHz.

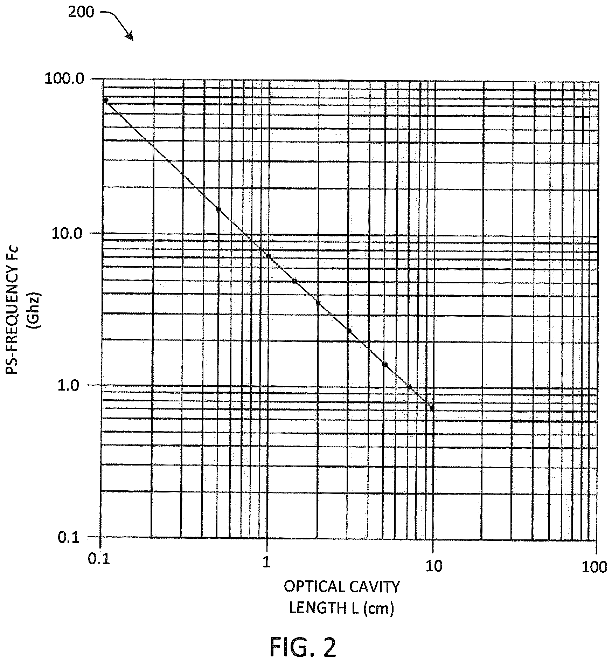

Referring to the graph 200 in FIG. 2, if however, the length of the optical cavity changes with time then the PS-frequency Fc will increase or decrease with shortening or lengthening of the optical cavity respectively. Therefore, Equation 1 is more appropriately written as Equation 2:

$$Fc(L) = c/4*L \qquad\qquad (Eq. 2)$$

As a result, since the cavity PS-frequency is dependent on the length of the optical cavity, an optical, non-contact sensor that includes a VCSEL can be implemented to determine the distance to a target object.

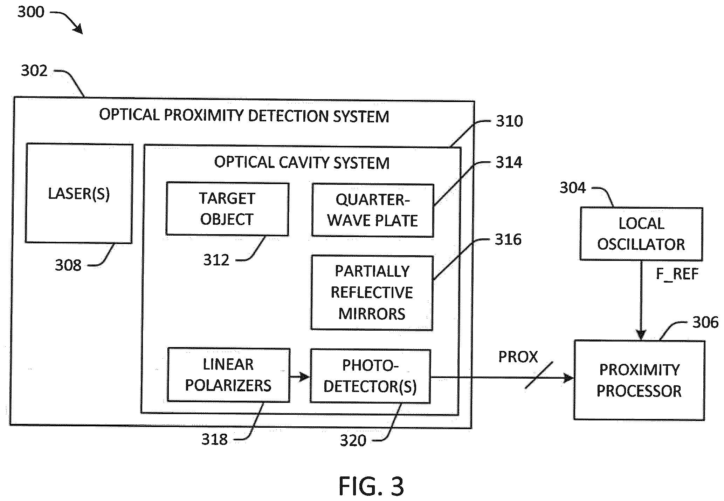

FIG. 3 illustrates an example optical proximity sensor system 300 configured to determine a distance to a target object. The optical proximity sensor system 300 can be implemented in applications for positioning or coupling objects to one another on, for example, a spacecraft. In space applications, remote positioning of and/or the docking of two or more objects without damaging either object is critical. Proximity/distance detection systems and methods used in terrestrial applications are ineffective or will not simply function in a space environment. The optical proximity sensor system 300 is effective in a space environment and can be configured to continually calculate a distance to a target object.

The optical proximity sensor system 300 includes an optical proximity detection system 302, a local oscillator 304, and a proximity processor 306. The optical proximity detection system 302 is configured to detect a distance to a target object. The optical proximity detection system 302 includes at least one laser 308 and an optical cavity system 310. The laser(s) 308 can be configured, for example, as vertical-cavity surface-emitting laser(s) (VCSEL), such as including a gain region that includes perpendicular stimulation axes. The laser(s) 308 are configured to generate an optical beam that alternates between linear polarizations, as described herein. For example, the laser(s) 308 can alternate between a first linear polarization, which could be a parallel polarization (i.e., p-polarization) relative to a first stimulation axis of the gain region of the laser(s) 308, and a second linear polarization, which could be a perpendicular polarization (i.e., s-polarization) relative to the first stimulation axis of the gain region of the laser(s) 308 based on providing a reflected optical beam back to the laser 308.

In order to obtain a measurement of the cavity PS-frequency Fc a small portion of the light from the laser 308 must be sampled from the optical cavity, passed through a linear polarizer and captured on a photodetector. Thus, in the example of FIG. 3, the optical cavity system 310 includes a target object 312, a quarter-wave plate 314, partially reflective mirrors (e.g., beamsplitters) 316, linear polarizers 318, and photodetectors 320. The target object 312 may or may not be in motion with respect to the laser 308.

The partially reflective mirrors 316 are angled with respect to a longitudinal axis of the optical cavity and divert a portion of the light from the laser(s) 308 such that the portion of the first linear polarization optical beam and a portion of the second linear polarization optical beam (i.e., reflected optical beam) is diverted and exits from a side of the optical cavity. Each diverted optical beam then passes through the linear polarizer 318 to the photodetectors 320. The linear polarizers 318 function as analyzers, which analyze and/or verify the state of polarization of the diverted optical beams.

The photodetectors 320 are configured to measure an intensity of the optical beam and the reflected optical beam from the target object and to generate a respective at least one proximity signal PROX. As an example, the proximity signal(s) PROX can be a pulsed signal and have a frequency that corresponds to the periodic oscillation between the emission of the parallel and perpendicular polarizations from the laser(s) 308. The frequency of the proximity signal(s) PROX can thus vary in response to the movement of the target object 312 relative to the laser 308(s). Therefore, the proximity signal(s) PROX can be indicative of the movement of the target object 312 in a direction towards or away from the laser(s) 308. The proximity signal(s) PROX is provided to the proximity processor 306 that is configured to calculate the distance to a target object. For example, the proximity processor 306 can compare the frequency of the proximity signal(s) with a predetermined reference frequency F_REF from the local oscillator 304. The difference in frequency between the proximity signal(s) and the reference frequency F_REF is used to determine the distance to the target object from, for example a lookup table.

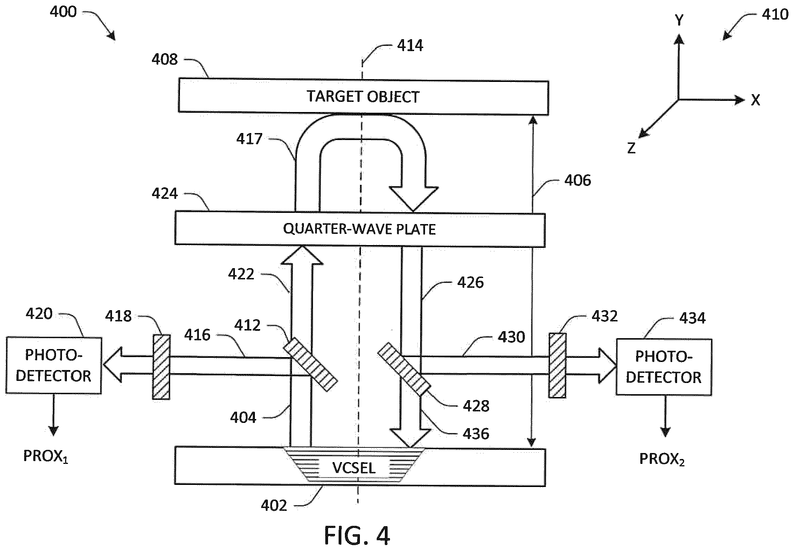

FIG. 4 illustrates an example optical proximity detection system 400 where a length of an optical cavity changes with time. The optical proximity detection system 400 can correspond to the optical proximity detection system 302 in the example of FIG. 3. Therefore, reference is to be made to the example of FIG. 3 in the following description of the example of FIG. 4.

The optical proximity detection system 400 includes a VCSEL 402 that is configured to generate an emitted optical beam 404 from an aperture through an optical cavity 406 and toward a target object 408 in approximately the direction of a Y-axis as demonstrated by the Cartesian coordinate system 410. The optical cavity 406 is defined by a distance between the VCSEL 402 and the target object 408. The emitted optical beam 404 has a first linear polarization (i.e., parallel or perpendicular) and engages a first partially reflective mirror 412 that is arranged at any angle with respect to a longitudinal axis 414 of the optical cavity 406. The first partially reflective mirror 412 diverts a portion (first diverted portion) 416 of the emitted optical beam 404 through a first linear polarizer 418 to a first photodetector 420. In one example, the first partially reflective mirror 412 can divert the portion of the emitted optical beam 404 at any angle with respect to the longitudinal axis 414 of the optical cavity 406 such that the first diverted portion 416 exits via a side of the optical cavity 406. In the example of FIG. 4, the first diverted portion 416 of the emitted optical beam 404 is diverted substantially perpendicular to the longitudinal axis 414 of the optical cavity 406.

A non-diverted portion 422 of the emitted optical beam 404 passes through the first partially reflective mirror 412 and travels through a quarter-wave plate 424. The quarter-wave plate 424 is configured to provide a quarter-wave retardance to the emitted optical beam 404 to convert the emitted optical beam 404 from the first linear polarization to a circular polarization 417. The emitted optical beam 404 reflects off the target object 408 back through the quarter-wave plate 424 as a reflected optical beam 426. The quarter-wave plate 424 however, converts the reflected optical beam 426 from a circular polarization 417 to a second linear polarization. Based on the additional quarter-wave retardance provided by the quarter-wave plate 424 however, the second linear polarization of the reflected optical beam 426 is orthogonal to the first linear polarization of the emitted optical beam 404. Therefore, if the emitted optical beam 404 has a perpendicular polarization, the reflected optical beam 426 has a parallel polarization. Conversely, if the emitted optical beam 404 has a parallel polarization, the reflected optical beam 426 has a perpendicular polarization.

The reflected optical beam 426 engages a second partially reflective mirror 428 that is arranged at any angle with respect to the longitudinal axis 414 of the optical cavity 406. The second partially reflective mirror 428 diverts a portion (second diverted portion) 430 of the reflected optical beam 426 substantially perpendicular to the longitudinal axis 414 of the optical cavity 406 such that the second diverted portion 430 exits via an opposite side of the optical cavity 406. The second diverted portion 430 travels through a second linear polarizer 432 to a second photodetector 434. A non-diverted portion 436 of the reflected optical beam 426 travels through the second partially reflective mirror back to the VCSEL 402.

The first and second photodetectors 420, 434 are configured to monitor an intensity of the emitted optical beam 404 and the reflected optical beam 426. As described previously, the VCSEL 402 can have a gain region that includes stimulation axes that are approximately orthogonal with respect to each other. Therefore, upon the reflected optical beam 426 being provided to the VCSEL 402, the reflected optical beam 426 begins to stimulate the stimulation axis that corresponds to the polarization of the reflected optical beam 426, and thus the stimulation axis that is orthogonal with respect to the emitted optical beam 404 from the VCSEL 402. As a result of the stimulation of the orthogonal stimulation axis, the VCSEL 402 switches the linear polarization of the emitted optical beam 404 to correspond to the stimulation axis that is stimulated by the reflected optical beam 426. Therefore, the linear polarization of the reflected optical beam 426 changes to the orthogonal polarization with respect to the emitted optical beam 404 based on the passing of both the emitted optical beam 404 and the reflected optical beam 426 through the quarter-wave plate 424. Accordingly, the VCSEL 402 oscillates between the linear polarizations (i.e., perpendicular and parallel) in providing the emitted optical beam 404.

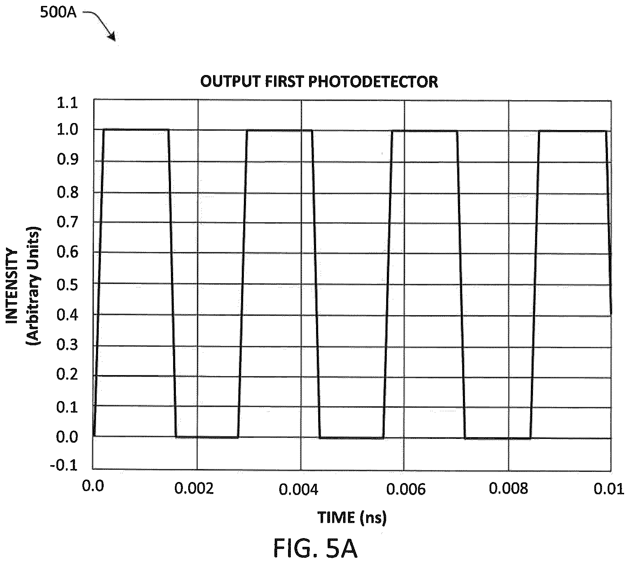

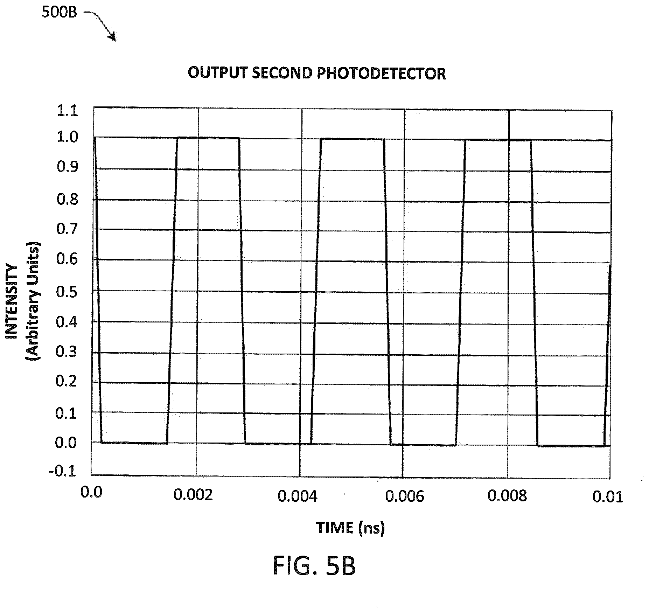

Referring to FIGS. 5A and 5B, the first and second photodetectors 420, 434 are configured to generate a proximity signal PROX, demonstrated as proximity signals $PROX_1$ and $PROX_2$ in the example of FIG. 4, that correspond to an intensity of the emitted optical beam 404 and of the reflected optical beam 426. For simplicity, FIGS. 5A and 5B are intensity output plots 500A, 500B from the first and second photodetectors 420, 434 respectively for a fixed optical cavity length. In the example in FIG. 4, the intensity output from the first and second photodetectors 420, 434 are complementary to each other. This is because the first and second linear polarizers 418, 432 are aligned to the same input angle, and as the linear polarization of the emitted optical beam 404 switches between the first and second linear polarizations only one of polarization is allowed to pass. It is possible to align the minima and the maxima of the two photodetectors 420, 434 by simply rotating one linear polarizer state 90° with respect to the other.

The change from an intensity output of approximately 1 to approximately 0 for the first photodetector 420 (vice versa for the second photodetector 434) represents a change in the linear polarization (i.e., between parallel and perpendicular linear polarizations) of the emitted optical beam 404. Therefore, the proximity signals $PROX_1$ and $PROX_2$ can have a frequency corresponding to the periodic transition between the first and second linear polarization of the VCSEL 402 based on a change of intensity from approximately 1 to approximately 0 for this example. Thus, the frequency of the proximity signals $PROX_1$ and $PROX_2$ of the first and second photodetectors 420, 434 respectively is representative of the distance to the target object. As mentioned above, a proximity processor can be configured to calculate the distance to the target object based on the frequency of the proximity signals $PROX_1$ and $PROX_2$, such as from a lookup table.

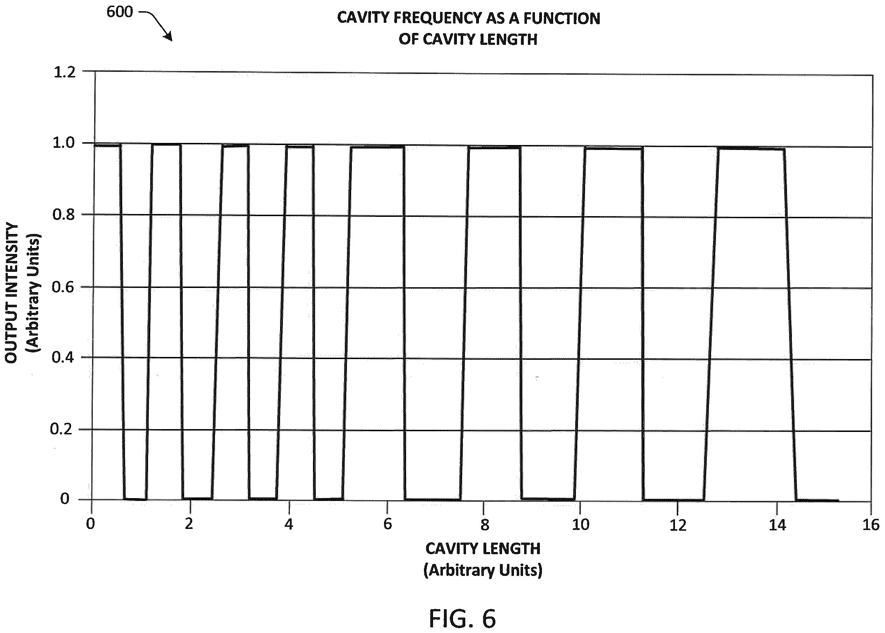

Referring to FIG. 6, the optical cavity length however, is not fixed but changes with time. As previously described, the change in the optical cavity length causes the PS-frequency of the optical cavity to change. FIG. 6 is a plot 600 of the cavity output frequency as a function of the optical cavity length. As illustrated, the period between maxima of the cavity output frequency becomes longer as the optical cavity length increases. Thus, the period and hence, the PS-frequency Fc of the optical cavity is representative of a distance to the target object.

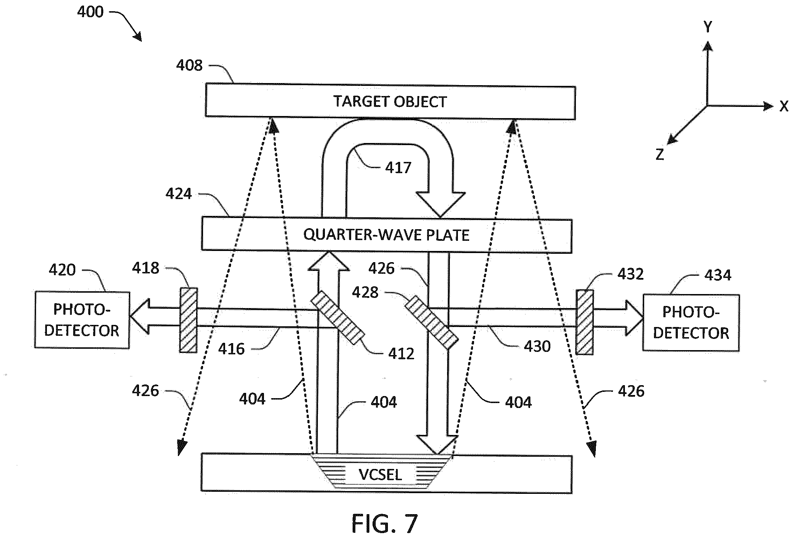

Referring to FIG. 7, in some applications the optical energy returning to the VCSEL may be sufficient to induce switching of the linear polarization from the first linear polarization to the second linear polarization. The emitted optical beam 404 however, from the VCSEL 402 is an un-collimated beam and therefore, diverges from the VCSEL 402 to the target object and back to the VCSEL 402. As a result, there is a loss in the amount of optical energy returning to the VCSEL 402. Thus, in other applications the optical energy returning to the VCSEL may be insufficient to induce switching of the linear polarization from the first linear polarization to the second linear polarization. In one example, a collimating lens can narrow the optical beam to reduce the loss of optical energy returning to the VCSEL. The collimating lens increases the amount of optical energy propagating within the optical cavity which boosts the signal-to-noise ratio (SNR) of the optical proximity sensor, and therefore extends the range of the optical proximity sensor.

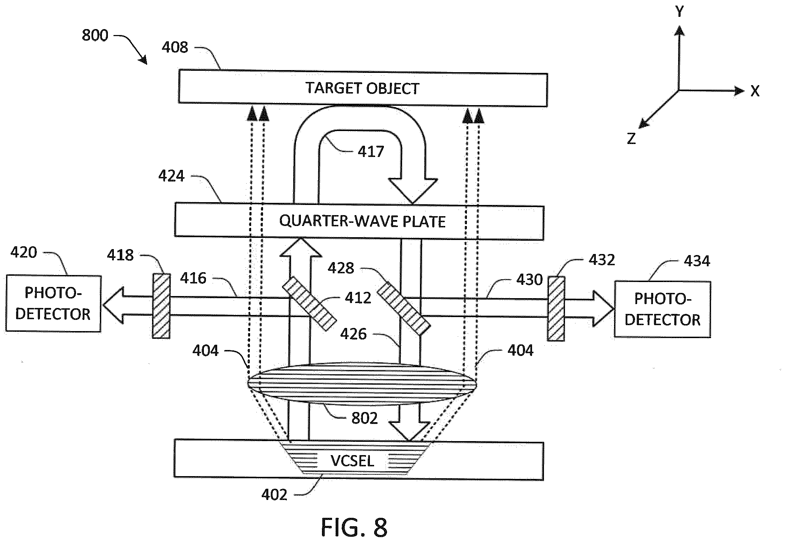

FIG. 8 illustrates another example of an optical proximity detection system 800. The optical proximity detection system 800 can correspond to the optical proximity detection system 302 in the example of FIG. 3 and is similar to the optical proximity detection system 400 illustrated in FIG. 4. Therefore, reference is to be made to the example of FIGS. 3 and 4 in the following description of the example of FIG. 8. In addition, like features will include the same reference numbers and will not be described in detail hereinafter.

The optical proximity detection system 800 illustrated in FIG. 8 further includes a collimator 802. The collimator 802 is positioned in line with the output of the VCSEL 402 such that the emitted optical beam 404 passes through the collimator 802. The collimator 802 aligns the emitted optical beam 404, which in turn causes the spatial cross section of the beam to narrow. The narrowing of the emitted optical beam 404 thus, allows more optical energy from the reflected optical beam 426 to re-enter the VCSEL 402. The collimator 802 thus, facilitates in producing an emitted optical beam 404 with sufficient optical energy where the reflected optical beam 426 provides the necessary feedback into the VCSEL 402 gain region to induce switching of the linear polarization from the first linear polarization to the second linear polarization.

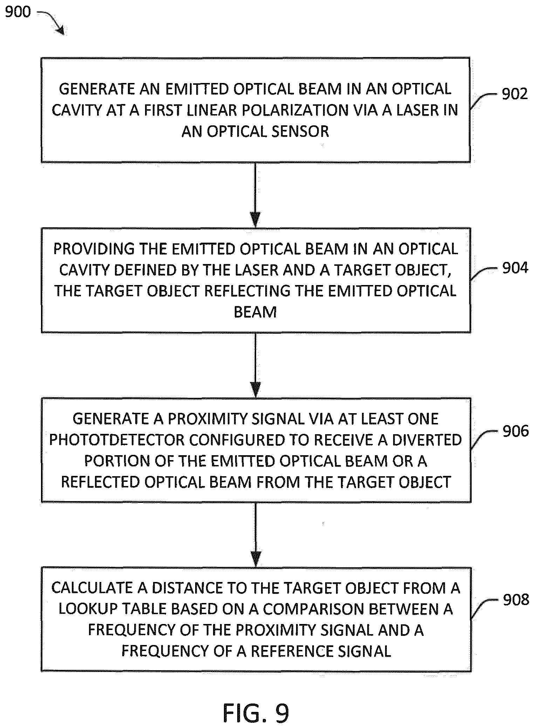

In view of the foregoing structural and functional features described above, a methodology in accordance with various aspects of the present invention will be better appreciated with reference to FIG. 9. While, for purposes of simplicity of explanation, the methodology of FIG. 9 is shown and described as executing serially, it is to be understood and appreciated that the present invention is not limited by the illustrated order, as some aspects could, in accordance with the present invention, occur in different orders and/or concurrently with other aspects from that shown and described herein. Moreover, not all illustrated features may be required to implement a methodology in accordance with an aspect of the present invention.

FIG. 9 illustrates an example of a method 900 for calculating a distance to a target object. At 902, a laser (e.g., laser 402) generates an emitted optical beam (e.g., emitted optical beam 404) at a first linear polarization. At 904, the emitted optical beam is provided in an optical cavity (e.g., optical cavity 406) defined by the laser and a target object (e.g., target object 408) where the target object is configured to reflect the emitted optical beam thereby generating a reflected optical beam (e.g., reflected optical beam 426). At 906, at least one proximity signal (e.g., proximity signals $PROX_1$ and $PROX_2$) having a frequency is generated via at least one photodetector (e.g., photodetectors 420, 434) configured to receive a diverted portion of at least one of the emitted optical beam and the reflected optical beam based on the diverted portion of the at least one of the emitted optical beam and the reflected optical beam. The frequency of the proximity signals can be indicative of a distance to the target object. At 908, a distance to the target object is calculated from, for example a lookup table, based on comparing the frequency of the proximity signals relative to a reference frequency signal.

The descriptions above constitute examples of the disclosure. It is, of course, not possible to describe every conceivable combination of components or method for purposes of describing the disclosure, but one of ordinary skill in the art will recognize that many further combinations and permutations of the disclosure are possible. Accordingly, the disclosure is intended to embrace all such alterations, modifications, and variations that fall within the scope of the invention as defined in the appended claims.

## Claims

1.    An optical proximity sensor system (400) comprising:

a laser (402) configured to generate an emitted optical beam (404) at a linear polarization;
an optical cavity system comprising an optical cavity (406) defined by a distance between the laser (402) and a target object (408), the target object (408) configured to reflect a portion of the emitted optical beam (404) thereby generating a reflected optical beam (426);
a first partially reflective mirror (412) configured to divert a portion (416) of the emitted optical beam (404);
a second partially reflective mirror (428) configured to divert a portion (430) of the reflected optical beam (426);
a first photodetector (420) configured to receive the diverted portion (416) of the emitted optical beam (404) and to generate a first proximity signal (PROX$_1$) having a first frequency that is indicative of the distance to the target object (408) based on the diverted portion (416) of the emitted optical beam (404);

a second photodetector (434) configured to receive the diverted portion (430) of the reflected optical beam (426) and to generate a second proximity signal (PROX$_2$) having a second frequency that is indicative of the distance to the target object (408) based on the diverted portion (430) of the reflected optical beam (426); and

a proximity processor configured to calculate the distance to the target object (408) based on the first frequency of the first proximity signal (PROX$_1$) and the second frequency of the second proximity signal (PROX$_2$).

2. The optical proximity sensor (400) system of claim 1, further comprising a first linear polarizer (418) configured to pass a first linear polarization and to block a second linear polarization of the diverted portion (416) of the emitted optical beam (404) from the first partially reflective mirror (412) to the first photodetector (420) to generate the first proximity signal (PROX$_1$) as a first pulsed signal having the first frequency and a second linear polarizer (432) configured to pass the first linear polarization and to block the second linear polarization of the diverted portion (430) of the reflected optical beam (426) from the second partially reflective mirror (428) to the second photodetector (434) to generate the second proximity signal (PROX$_2$) as a second pulsed signal having the second frequency.

3. The optical proximity sensor system (400) of claim 2, further comprising a quarter-wave plate (424) arranged between the laser (402) and the target object (408) and configured to convert the emitted optical beam (404) from the first linear polarization to a circular-polarization (417) and to convert the reflected optical beam(426) from the circular-polarization (417) to the second linear polarization, and is further configured to convert the emitted optical beam (404) from the second linear polarization to the circular-polarization (417) and to convert the reflected optical beam (426) from the circular-polarization (417) to the first linear polarization.

4. The optical proximity sensor system (400) of claim 3, wherein the laser (402) is configured as a vertical-cavity surface-emitting laser, VCSEL, configured to oscillate between generating the emitted optical beam (404) at the first linear polarization and generating the emitted optical beam (404) at the second linear polarization in response to the VCSEL receiving the reflected optical beam (426).

5. The optical proximity sensor system (400) of claim 4, further comprising a collimating lens that aligns the emitted optical beam (404) thereby narrowing a spatial cross section of the emitted optical beam (404) to allow more optical energy from the reflected optical beam (426) to re-enter the VCSEL.

6. The optical proximity sensor system (400) of claim 4, wherein the second frequency of the second proximity signal (PROX$_2$) corresponds to periodic transitions of the oscillation between the first linear polarization and the second linear polarization of the reflected optical beam (426), and wherein the proximity processor is configured to calculate the distance to the target object (408) based on the second frequency of the periodic transitions of the second proximity signal (PROX$_2$).

7. The optical proximity sensor system (400) of claim 4, further comprising a local oscillator configured to generate a reference frequency signal, wherein the proximity processor is configured to determine the distance to the target object (408) based on a comparison between the reference frequency signal and the proximity signal (PROX$_1$, PROX$_2$).

8. A method (900) for measuring a distance, the method comprising:

generating (902) an emitted optical beam at a linear polarization via a laser;
providing (904) the emitted optical beam in an optical cavity defined by the laser and a target object, the target object configured to reflect the emitted optical beam generating a reflected optical beam;
diverting a portion of the emitted optical beam with a first partially reflective mirror to a first photodetector;
diverting a portion of the reflected optical beam with a second partially reflective mirror to a second photodetector;
generating (906) a first proximity signal having a first frequency via the first photodetector, the first frequency of the first proximity signal being indicative of the distance to the target object based on the diverted portion of the emitted optical beam;
generating (906) a second proximity signal having a second frequency via the second photodetector, the second frequency of the second proximity signal being indicative of the distance to the target object based on the diverted portion of the reflected optical beam; and
calculating (908) the distance to the target object based on comparing the first frequency of the first proximity signal or the second frequency of the second proximity signal relative to a reference frequency signal.

9. The method (900) of claim 8, wherein generating (902) the emitted optical beam comprises periodically switching the linear polarization of the emitted optical beam between a first linear polarization and a second linear polarization.

10. The method (900) of claim 9, wherein the laser is a VCSEL and wherein the periodic switching is based on providing the reflected optical beam to the VCSEL.

11. The method (900) of claim 9, wherein generating (906) the first proximity signal and the second proximity signal comprises generating the first proximity signal and the second proximity signal such that the first frequency of the first proximity signal and the second frequency of the second proximity signal are based on a frequency of a periodic switching of the linear polarization of the emitted optical beam between a first linear polarization and a second linear polarization.

**Patentansprüche**

1. Ein optisches Näherungssensorsystem (400), das Folgendes umfasst:

einen Laser (402), der so konfiguriert ist, dass er einen emittierten optischen Strahl (404) mit einer linearen Polarisation erzeugt;
ein optisches Hohlraumsystem mit einem optischen Hohlraum (406), der durch einen Abstand zwischen dem Laser (402) und einem Zielobjekt (408) definiert ist, wobei das Zielobjekt (408) so konfiguriert ist, dass es einen Teil des emittierten optischen Strahls (404) reflektiert und dadurch einen reflektierten optischen Strahl (426) erzeugt;
einen ersten teilreflektierenden Spiegel (412), der so konfiguriert ist, dass er einen Teil (416) des ausgesandten optischen Strahls (404) ablenkt;
einen zweiten teilreflektierenden Spiegel (428), der so konfiguriert ist, dass er einen Teil (430) des reflektierten optischen Strahls (426) ablenkt;
einen ersten Photodetektor (420), der so konfiguriert ist, dass er den abgelenkten Teil (416) des emittierten optischen Strahls (404) empfängt und ein erstes Annäherungssignal ($PROX_1$) mit einer ersten Frequenz erzeugt, das den Abstand zum Zielobjekt (408) auf der Grundlage des abgelenkten Teils (416) des emittierten optischen Strahls (404) anzeigt;
einen zweiten Photodetektor (434), der so konfiguriert ist, dass er den abgelenkten Teil (430) des reflektierten optischen Strahls (426) empfängt und ein zweites Annäherungssignal ($PROX_2$) mit einer zweiten Frequenz erzeugt, das den Abstand zu dem Zielobjekt (408) auf der Grundlage des abgelenkten Teils (430) des reflektierten optischen Strahls (426) anzeigt; und
einen Annäherungsprozessor, der so konfiguriert ist, dass er die Entfernung zu dem Zielobjekt (408) auf der Grundlage der ersten Frequenz des ersten Annäherungssignals ($PROX_1$) und der zweiten Frequenz des zweiten Annäherungssignals ($PROX_2$) berechnet.

2. Das optische Näherungssensorsystem (400) nach Anspruch 1, ferner umfassend einen ersten linearen Polarisator (418), der so konfiguriert ist, dass er eine erste lineare Polarisation durchlässt und eine zweite lineare Polarisation des abgelenkten Teils (416) des emittierten optischen Strahls (404) von dem ersten teilreflektierenden Spiegel (412) zu dem ersten Photodetektor (420) blockiert, um das erste Annäherungssignal ($PROX_1$) als ein erstes gepulstes Signal mit der ersten Frequenz zu erzeugen und einen zweiten linearen Polarisator (432), der so konfiguriert ist, dass er die erste lineare Polarisation durchlässt und die zweite lineare Polarisation des abgelenkten Teils (430) des reflektierten optischen Strahls (426) von dem zweiten teilreflektierenden Spiegel (428) zu dem zweiten Fotodetektor (434) blockiert, um das zweite Annäherungssignal ($PROX_2$) als ein zweites gepulstes Signal mit der zweiten Frequenz zu erzeugen.

3. Das optische Näherungssensorsystem (400) nach Anspruch 2, das ferner eine Viertelwellenplatte (424) umfasst, die zwischen dem Laser (402) und dem Zielobjekt (408) angeordnet und so konfiguriert ist, dass sie den emittierten optischen Strahl (404) von der ersten linearen Polarisation in eine zirkulare Polarisation (417) umwandelt und den reflektierten optischen Strahl (426) von der zirkularen Polarisation (417) in die zweite lineare Polarisation umwandelt, und ferner so konfiguriert ist, dass sie den ausgesandten optischen Strahl (404) von der zweiten linearen Polarisation in die zirkulare Polarisation (417) umwandelt und den reflektierten optischen Strahl (426) von der zirkularen Polarisation (417) in die erste lineare Polarisation umwandelt.

4. Das optische Näherungssensorsystem (400) nach Anspruch 3, wobei der Laser (402) als oberflächenemittierender Laser mit vertikalem Resonator (VCSEL) konfiguriert ist, der so konfiguriert ist, dass er als Reaktion auf den Empfang des reflektierten optischen Strahls (426) durch den VCSEL zwischen der Erzeugung des emittierten optischen Strahls (404) mit der ersten linearen Polarisation und der Erzeugung des emittierten optischen Strahls (404) mit der zweiten linearen Polarisation schwankt.

**5.** Das optische Näherungssensorsystem (400) nach Anspruch 4 umfasst ferner eine Kollimationslinse, die den emittierten optischen Strahl (404) ausrichtet und dadurch einen räumlichen Querschnitt des emittierten optischen Strahls (404) verengt, damit mehr optische Energie aus dem reflektierten optischen Strahl (426) wieder in den VCSEL eintreten kann.

**6.** Das optische Näherungssensorsystem (400) nach Anspruch 4, wobei die zweite Frequenz des zweiten Näherungssignals (PROX$_2$) periodischen Übergängen der Oszillation zwischen der ersten linearen Polarisation und der zweiten linearen Polarisation des reflektierten optischen Strahls (426) entspricht, und wobei der Näherungsprozessor so konfiguriert ist, dass er die Entfernung zu dem Zielobjekt (408) auf der Grundlage der zweiten Frequenz der periodischen Übergänge des zweiten Näherungssignals (PROX$_2$) berechnet.

**7.** Das optische Näherungssensorsystem (400) nach Anspruch 4, das ferner einen lokalen Oszillator umfasst, der so konfiguriert ist, dass er ein Referenzfrequenzsignal erzeugt, wobei der Näherungsprozessor so konfiguriert ist, dass er die Entfernung zu dem Zielobjekt (408) auf der Grundlage eines Vergleichs zwischen dem Referenzfrequenzsignal und dem Näherungssignal (PROX$_1$, PROX$_2$) bestimmt.

**8.** Ein Verfahren (900) zum Messen einer Entfernung, wobei das Verfahren umfasst:

Erzeugung (902) eines optischen Strahls mit linearer Polarisation durch einen Laser;
Bereitstellen (904) des emittierten optischen Strahls in einem optischen Hohlraum, der durch den Laser und ein Zielobjekt definiert ist, wobei das Zielobjekt so konfiguriert ist, dass es den emittierten optischen Strahl reflektiert und einen reflektierten optischen Strahl erzeugt;
Umlenkung eines Teils des emittierten optischen Strahls mit einem ersten teilreflektierenden Spiegel auf einen ersten Photodetektor;
Umlenkung eines Teils des reflektierten optischen Strahls mit einem zweiten teilreflektierenden Spiegel auf einen zweiten Photodetektor;
Erzeugen (906) eines ersten Annäherungssignals mit einer ersten Frequenz über den ersten Photodetektor, wobei die erste Frequenz des ersten Annäherungssignals die Entfernung zu dem Zielobjekt auf der Grundlage des abgelenkten Teils des emittierten optischen Strahls angibt;
Erzeugen (906) eines zweiten Annäherungssignals mit einer zweiten Frequenz über den zweiten Photodetektor, wobei die zweite Frequenz des zweiten Annäherungssignals die Entfernung zu dem Zielobjekt basierend auf dem abgelenkten Teil des reflektierten optischen Strahls anzeigt; und
Berechnen (908) der Entfernung zu dem Zielobjekt auf der Grundlage des Vergleichs der ersten Frequenz des ersten Annäherungssignals oder der zweiten Frequenz des zweiten Annäherungssignals relativ zu einem Referenzfrequenzsignal.

**9.** Das Verfahren (900) nach Anspruch 8, wobei das Erzeugen (902) des emittierten optischen Strahls das periodische Umschalten der linearen Polarisation des emittierten optischen Strahls zwischen einer ersten linearen Polarisation und einer zweiten linearen Polarisation umfasst.

**10.** Das Verfahren (900) nach Anspruch 9, bei dem der Laser ein VCSEL ist und bei dem das periodische Schalten darauf beruht, dass der reflektierte optische Strahl dem VCSEL zugeführt wird.

**11.** Das Verfahren (900) nach Anspruch 9, wobei das Erzeugen (906) des ersten Annäherungssignals und des zweiten Annäherungssignals das Erzeugen des ersten Annäherungssignals und des zweiten Annäherungssignals derart umfasst, dass die erste Frequenz des ersten Annäherungssignals und die zweite Frequenz des zweiten Annäherungssignals auf einer Frequenz eines periodischen Umschaltens der linearen Polarisation des emittierten optischen Strahls zwischen einer ersten linearen Polarisation und einer zweiten linearen Polarisation basieren.

**Revendications**

**1.** Un système de capteur de proximité optique (400) comprenant:

un laser (402) configuré pour générer un faisceau optique émis (404) à une polarisation linéaire;

un système de cavité optique comprenant une cavité optique (406) définie par une distance entre le laser (402) et un objet cible (408), l'objet cible (408) étant configuré pour réfléchir une partie du faisceau optique émis (404) et générer ainsi un faisceau optique réfléchi (426);

un premier miroir partiellement réfléchissant (412) configuré pour dévier une partie (416) du faisceau optique émis (404);

un second miroir partiellement réfléchissant (428) configuré pour dévier une partie (430) du faisceau optique réfléchi (426);

un premier photodétecteur (420) configuré pour recevoir la partie déviée (416) du faisceau optique émis (404) et pour générer un premier signal de proximité ($PROX_1$) ayant une première fréquence qui est indicative de la distance à l'objet cible (408) sur la base de la partie déviée (416) du faisceau optique émis (404);

un second photodétecteur (434) configuré pour recevoir la partie déviée (430) du faisceau optique réfléchi (426) et pour générer un second signal de proximité ($PROX_2$) ayant une seconde fréquence qui est indicative de la distance à l'objet cible (408) sur la base de la partie déviée (430) du faisceau optique réfléchi (426); et

un processeur de proximité configuré pour calculer la distance par rapport à l'objet cible (408) sur la base de la première fréquence du premier signal de proximité ($PROX_1$) et de la seconde fréquence du second signal de proximité ($PROX_2$).

2. Le système de capteur de proximité optique (400) de la revendication 1, comprenant en outre un premier polariseur linéaire (418) configuré pour faire passer une première polarisation linéaire et pour bloquer une seconde polarisation linéaire de la partie déviée (416) du faisceau optique émis (404) depuis le premier miroir partiellement réfléchissant (412) vers le premier photodétecteur (420) pour générer le premier signal de proximité ($PROX_1$) en tant que premier signal pulsé ayant la première fréquence et un second polariseur linéaire (432) configuré pour laisser passer la première polarisation linéaire et pour bloquer la seconde polarisation linéaire de la partie déviée (430) du faisceau optique réfléchi (426) du second miroir partiellement réfléchissant (428) vers le second photodétecteur (434) afin de générer le second signal de proximité ($PROX_2$) en tant que second signal pulsé ayant la seconde fréquence.

3. Le système de capteur optique de proximité (400) de la revendication 2, comprenant en outre une lame quart d'onde (424) disposée entre le laser (402) et l'objet cible (408) et configurée pour convertir le faisceau optique émis (404) de la première polarisation linéaire à une polarisation circulaire (417) et pour convertir le faisceau optique réfléchi (426) de la polarisation circulaire (417) à la deuxième polarisation linéaire, et est en outre configuré pour convertir le faisceau optique émis (404) de la seconde polarisation linéaire à la polarisation circulaire (417) et pour convertir le faisceau optique réfléchi (426) de la polarisation circulaire (417) à la première polarisation linéaire.

4. Le système de capteur optique de proximité (400) de la revendication 3, dans lequel le laser (402) est configuré comme un laser à cavité verticale émettant par la surface, VCSEL, configuré pour osciller entre la génération du faisceau optique émis (404) à la première polarisation linéaire et la génération du faisceau optique émis (404) à la seconde polarisation linéaire en réponse au VCSEL recevant le faisceau optique réfléchi (426).

5. Le système de capteur optique de proximité (400) de la revendication 4 comprend en outre une lentille de collimation qui aligne le faisceau optique émis (404), réduisant ainsi la section transversale spatiale du faisceau optique émis (404) pour permettre à une plus grande quantité d'énergie optique provenant du faisceau optique réfléchi (426) de pénétrer à nouveau dans le VCSEL.

6. Le système de capteur optique de proximité (400) de la revendication 4, dans lequel la deuxième fréquence du deuxième signal de proximité ($PROX_2$) correspond aux transitions périodiques de l'oscillation entre la première polarisation linéaire et la deuxième polarisation linéaire du faisceau optique réfléchi (426), et dans lequel le processeur de proximité est configuré pour calculer la distance par rapport à l'objet cible (408) sur la base de la deuxième fréquence des transitions périodiques du deuxième signal de proximité ($PROX_2$).

7. Le système de capteur optique de proximité (400) de la revendication 4, comprenant en outre un oscillateur local configuré pour générer un signal de fréquence de référence, dans lequel le processeur de proximité est configuré pour déterminer la distance par rapport à l'objet cible (408) sur la base d'une comparaison entre le signal de fréquence de référence et le signal de proximité ($PROX_1$, $PROX_2$).

8. Une méthode (900) pour mesurer une distance, la méthode comprenant:

générer (902) un faisceau optique émis à une polarisation linéaire par l'intermédiaire d'un laser;

fournir (904) le faisceau optique émis dans une cavité optique définie par le laser et un objet cible, l'objet cible étant configuré pour réfléchir le faisceau optique émis et générer un faisceau optique réfléchi;

détourner une partie du faisceau optique émis à l'aide d'un premier miroir partiellement réfléchissant vers un premier photodétecteur;

détourner une partie du faisceau optique réfléchi avec un second miroir partiellement réfléchissant vers un second photodétecteur;

générer (906) un premier signal de proximité ayant une première fréquence via le premier photodétecteur, la première fréquence du premier signal de proximité étant indicative de la distance par rapport à l'objet cible sur la base de la partie détournée du faisceau optique émis;

générer (906) un second signal de proximité ayant une seconde fréquence via le second photodétecteur, la seconde fréquence du second signal de proximité étant indicative de la distance à l'objet cible sur la base de la partie détournée du faisceau optique réfléchi; et

calculer (908) la distance par rapport à l'objet cible en comparant la première fréquence du premier signal de proximité ou la seconde fréquence du second signal de proximité par rapport à un signal de fréquence de référence.

9. La méthode (900) de la revendication 8, dans laquelle la génération (902) du faisceau optique émis comprend la commutation périodique de la polarisation linéaire du faisceau optique émis entre une première polarisation linéaire et une seconde polarisation linéaire.

10. La méthode (900) de la revendication 9, dans laquelle le laser est un VCSEL et dans laquelle la commutation périodique est basée sur la fourniture du faisceau optique réfléchi au VCSEL.

11. La méthode (900) de la revendication 9, dans laquelle la génération (906) du premier signal de proximité et du second signal de proximité comprend la génération du premier signal de proximité et du second signal de proximité de telle sorte que la première fréquence du premier signal de proximité et la seconde fréquence du second signal de proximité sont basées sur une fréquence de commutation périodique de la polarisation linéaire du faisceau optique émis entre une première polarisation linéaire et une seconde polarisation linéaire.

100

106

MIRROR

112

110

OPTICAL
CAVITY
102
(L)

QUARTER-WAVE PLATE

108

114

VCSEL

104

FIG. 1

FIG. 2

FIG. 3

FIG. 4

EP 4 123 907 B1

500A

**OUTPUT FIRST PHOTODETECTOR**

FIG. 5A

FIG. 5B

CAVITY FREQUENCY AS A FUNCTION
OF CAVITY LENGTH

600

FIG. 6

EP 4 123 907 B1

FIG. 7

EP 4 123 907 B1

FIG. 8

EP 4 123 907 B1

900

GENERATE AN EMITTED OPTICAL BEAM IN AN OPTICAL CAVITY AT A FIRST LINEAR POLARIZATION VIA A LASER IN AN OPTICAL SENSOR — 902

PROVIDING THE EMITTED OPTICAL BEAM IN AN OPTICAL CAVITY DEFINED BY THE LASER AND A TARGET OBJECT, THE TARGET OBJECT REFLECTING THE EMITTED OPTICAL BEAM — 904

GENERATE A PROXIMITY SIGNAL VIA AT LEAST ONE PHOTOTDETECTOR CONFIGURED TO RECEIVE A DIVERTED PORTION OF THE EMITTED OPTICAL BEAM OR A REFLECTED OPTICAL BEAM FROM THE TARGET OBJECT — 906

CALCULATE A DISTANCE TO THE TARGET OBJECT FROM A LOOKUP TABLE BASED ON A COMPARISON BETWEEN A FREQUENCY OF THE PROXIMITY SIGNAL AND A FREQUENCY OF A REFERENCE SIGNAL — 908

FIG. 9

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 3223540 A1

**Non-patent literature cited in the description**

- **SEIICHI KAKUMA et al.** *Practical Accurate Optical Ranging Based on Polarization Self Modulation of a Vertical-Cavity Surface-Emitting Laser Diode,* ISSN 1349-9432